# EUROPEAN PATENT SPECIFICATION

(11) **EP 0 346 525 B1**
(45) Date of publication and mention of the grant of the patent: **04.09.1996**
(21) Application number: 88118473.3
(22) Date of filing: 05.11.1988
(51) Int. Cl.: H05K 3/46, H01R 4/04, H05K 1/00

(54) **Multilayer electronic circuit and method of manufacture**
Elektronische Mehrschichtschaltung und Verfahren zur Herstellung
Circuit électronique multicouche et procédé de fabrication

(30) Priority: 10.06.1988 US 206086
(43) Date of publication of application: 20.12.1989
(73) Proprietor: Sheldahl, Inc., Northfield Minnesota 55057 (US)
(72) Inventor: Gilleo, Kenneth B., Dr., Northfield Minnesota 55057 (US); Dowdle, Deanna M., Northfield Minnesota 55057 (US)
(74) Representative: Weber, Dieter, Dr.

(56) References cited:
- EP-A- 0 147 856
- EP-A- 0 170 703
- EP-A- 0 265 212
- FR-A- 2 475 302
- US-A- 3 795 047

## Description

### Background of the Invention

In the prior art electronic circuits have traditionally been made in two dimensions, i.e. circuit patterns have been formed in a single plane and electronic components have been directly connected to the planar circuit pattern. This has become well known as the traditional "circuit board". There was frequently insufficient space on the traditional circuit board to fit all circuit patterns and components required to accomplish the electronic objective. This has continued to be true in spite of significant advances in reduction of size of circuit patterns through photoresist and other techniques and in spite of significant advances in miniaturization of circuit components. In such a case a plurality of different circuit boards were used which were interconnected by electrical conductors, usually electrical wires. The wiring together of a plurality of such circuit boards often became exceedingly complex and space consuming. In addition the relatively long runs of wiring, especially in modern electronic computer applications, required an undesirably long time to transfer an electronic signal. Furthermore, the cost of such wiring and the difficulty and time required to make all of the connections has been significant.

In an attempt to overcome some of the disadvantages of the traditional two dimensional circuit board, double sided circuits were developed. The double sided circuits comprise two circuit layer pairs each pair in turn comprising an insulating layer having opposing surfaces and having a circuit pattern on each of the opposing surfaces of the insulating layer. The patterns in each pair are connected by means of conductors passing through the insulating layer. These double sided circuits have now become commonplace and may be manufactured by well known techniques.

Briefly such traditional double sided circuits are usually manufactured by forming electronic circuit patterns on opposing surfaces of an insulating layer such as a sheet or board made of an insulating resin. Such patterns are formed by known methods such as electroless and electrolytic plating of the opposing surfaces of the insulating layer with a conductive metal, laying down a photoresist over the conductive metal platings, exposing the photoresist to a light or other radiation image of the desired circuit pattern, removing unexposed photoresist and etching away that portion of the conductive metal plating, from which unexposed photoresist has been removed, to leave the desired conductive circuit patterns.

After formation of the patterns on opposing sides of the insulating layer, the patterns are connected by drilling holes through the insulating layer at desired points of electrical connection and plating the holes with a conductive metal to form the electrical connections. A method similar to the one described above is disclosed in U.S. Patent 4,610,756.

While double sided circuits, as previously described, significantly increased circuit density, essentially forming two circuit patterns in little more than the space of a prior art single pattern, the density has still not been as high as desired and a number of such double sided circuits still have to frequently be connected by wires to accomplish the electronic objective. Attempts have therefore been made to make multilayer electronic circuits, i.e. comprising three or more electronic circuit pattern layers.

Conventional multilayer circuits have been made by methods which are an extension of the above method for the manufacture of double sided circuits. Conventional multilayers have been made by imaging, exposing, and etching various inner layers of circuitry and then bringing all layers together in alignment. The layers are then laminated together in plies using a suitable insulating adhesive. The multilayer product is then usually pressed, e.g. by means of a platen. Subsequent to pressing a cure of the adhesive is often required. Through holes are then drilled to form barrels which are plated to create electrical contact between layers.

Unfortunately many problems are associated with both this prior art multilayer product and the method for its manufacture. In particular, precise alignment of all layers is required simultaneously and such precise alignment is very difficult. The more layers involved, the more difficult is the alignment. Failure to align properly creates a high probability that the through holes will not contact all desired electrical connection points and perhaps will contact undesired electrical contact points thus creating undesired "short circuits" , either of which will create an unusable multilayer electronic circuit product.

Another problem is associated with the drilling of the holes, in that adhesive tends to smear in the holes thus creating an unsuitable surface for through hole plating and creating an insulating layer which can prevent electrical contact with a circuit pattern layer at the desired location. Burrs formed by drilling can create another series of problems. Cleaning of the through holes to eliminate adhesive is usually essential and the elimination of burrs is at least desirable prior to plating. Cleaning of the through holes is made more difficult as the number of layers increases.

Another problem associated with the manufacture of these prior art multilayer circuits is that proper electrical contact with each desired layer becomes less certain as the number of layers increases. This is true not only statistically but because the only part of an internal circuit pattern available for contact in the hole is the extremely thin edge of the pattern layer. The probability of making good electrical contact is further reduced by the possible presence of insulating adhesive in the hole as previously discussed. Even if contact is made a significant potential for later failure exists. The thermal coefficient of expansion of the insulating layers, including the cured adhesive, is usually much different than the electrically conductive materials used in the formation of the circuit patterns and in plating the through holes. Environmental thermal cycling or solder heat exposure therefore creates a serious risk for failure. This risk is further enhanced by the mechanically weak contact made in the through holes at the edges of the circuit layers, as previously discussed.

Another disadvantage of such prior art multilayer circuits is the extreme difficulty of forming internal connections between layers. The holes as previously discussed are usually through holes which are plated all the way through. It is difficult to partially plate the holes to connect only some of the layers and in any case even an unplated hole will disrupt the surface of layers which are not to be connected. It is also difficult to form blind or partial holes and when both ends of such blind holes are to be covered by other layers, such a construction is impossible unless partial preassembly techniques are used.

While many of the problems, discussed above, have been previously recognized, and numerous attempts have been made to solve them, until now there has been no reasonable method for preparation of multilayer electronic circuits which reduces or eliminates such problems, at least not without introducing further serious additional problems and complexities.

Some of the problems have for example been discussed in U.S. Patents 4,642,160; 4,511,757; and 4,628,022 and attempts have been made to alleviate them. U.S. Patents 4,511,757 and 4,628,022 rely upon radiation formed vias (holes) which are filled with conductive material. The method substitutes forming holes with radiation for forming holes by drilling with attendant complexities associated with such a process. The process has the further disadvantage that such "vias" cannot be made more than one layer deep thus requiring special treatment at every individual interface prior to addition of further layers. U.S. Patent 4,642,160 is similarly concerned with alternate hole forming methods.

U.S. Patent 4,645,552 discloses using a tape which is provided with vias which are subsequently filled with a conductive material by plating. The steps must be individually repeated for each layer. U.S. Patent 4,581,679 similarly uses holes except instead of filling them or plating them with a conductive material, deformed conductive material is inserted into the holes to make contact with circuit patterns by spring action.

Other attempts have been made to make multilayer circuits by repeated use of plating and photoresist techniques. Such methods are clearly very complex and expensive. Such a method is disclosed in U.S. Patent 4,629,681 and a somewhat similar method is described in U.S. Patent 4,713,494.

It has been known in the prior art that certain anisotropically conductive adhesives could be used to connect one electrical conductor to another. Such an adhesive is disclosed in U.S. Patent 4,113,981. There is however no disclosure or suggestion in that patent of any particular advantage, purpose or way to use such an adhesive in the manufacture of multilayer electronic circuits.

A fusible anisotropic adhesive is described in copending U.S. patent application serial number 911,342, filed by coinventor Gilleo herein, on September 25, 1986 (EP-A-0 265 077). Again there is no disclosure or suggestion of any purpose or way to use such an adhesive in the preparation of a multilayer electronic circuit.

US-A-3 795 047 shows a multilayer electronic circuit comprising at least three electronic circuit layers electrically interconnected to one another wherein at least two of said circuit layers are interconnected by at least one interposed connecting layer which is conductive in the Z-axis because of an adhesive with dispersed metal particles have size about equal to the connected distance between said layers, said particles being sufficiently concentrated to insure electrical contact through the Z-axis of the connecting layer between conductive portions of the circuit layers which are directly opposite each other.

### Brief Description of the Drawings

Figure 1 is a front cross-sectional view of a multilayer electronic circuit of the invention.

Figure 2 is a an exploded front-sectional perspective view of the circuit of Figure 1.

### Brief Description of the Invention

In accordance with an aspect of the present invention as defined in claim 1, a multilayer electronic circuit is provided which comprises at least three electronic circuit layers electrically interconnected by means of at least one interposed connecting layer which is conductive only in the Z-axis. Desirably at least four circuit layers are provided in two circuit layer pairs. Each pair comprises an insulating layer having opposing surfaces and having a circuit pattern on each of the opposing surfaces of the insulating layer. The patterns in each pair are connected by means of conductors passing through the insulating layer. The thus formed pairs are connected to each other by means of a connecting layer interposed between one such pattern from each of said pairs.

The connecting layer preferably comprises an electrically insulating material, such as a resin, which contains electrically conductive particles. The quantity of the particles is statistically selected so as to be sufficiently dispersed to prevent electrical conduction along the X and Y axes of the connecting layer and sufficiently concentrated and of a size to insure electrical contact through the Z-axis of the connecting layer between conductive portions of said circuit layers which are in contact with the connecting layer and directly opposite each other through the connecting layer. The connecting layer is thus said to be anisotropically (Z-axis) conductive.

In accordance with another aspect of the invention as defined in claim 13, a method for making a multilayer electronic circuit is provided, comprising:
a) making circuit layer pairs each pair comprising an insulating layer having opposing surfaces and having a circuit pattern on each of the opposing surfaces of the insulating layer, which patterns in each pair are connected by means of conductors passing through the insulating layer; and
b) connecting at least two of such pairs by interposing an adhesive connecting layer between one pattern from each of said pairs, said adhesive connecting layer comprising an electrically insulating resin containing electrically conductive particles. The quantity of the particles is statistically selected so as to be sufficiently dispersed to prevent electrical conduction along the X and Y axes of the connecting layer and sufficiently concentrated and of a size to insure electrical contact through the Z-axis thickness of the connecting layer between desired conductive portions of the circuit patterns which are in contact with the connecting layer and directly opposite each other through the connecting layer.

The method and multilayer circuit of the present invention reduce or eliminate many of the previously mentioned problems associated with multilayer electronic circuits of the prior art and with prior art methods for their manufacture.

In particular, alignment of the layers prior to connecting them, while still being important, is not nearly as critical. This is true since alignment with the next adjacent circuit layer is all that is required. Since through holes, except in layer pairs, are not used, alignment with remote circuit layers is not necessary, thus combination of errors does not occur.

Additionally, since through holes passing through numerous layers are not used, the problems associated with drilling, cleaning and plating them are eliminated, as are problems associated with the difficulty of making good electrical contact at edges of circuit patterns.

Furthermore, the multilayer circuits of the present invention are more resistant to thermal stress because of better electrical contact with the circuit layers as a result of surface, as opposed to edge contact, with the circuit layers and also because thermal expansion effects are limited to layer to layer contact when the anisotropic layers of the invention are used, rather than being additive through all layers as could be the case when through holes were used.

Another advantage of the present invention, over the prior art, is that electrical contacts can be made from layer to layer without concern for whether similar contacts are being made at the same vertical location on remote layers. This flexibility of location of contacts was not possible or at a minimum was tremendously difficult in prior art multilayer circuits as previously described.

### Detailed Description Of The Invention

"Electronic circuit" as used herein means an interconnection of a number of devices and/or conductors in one or more closed paths, or any part of such a path whether or not immediately connected, to perform a desired electrical or electronic function. The path may comprise conductors or semiconductors or combinations thereof. The conductors may be of any suitable material including, but not limited to copper. Similarly any suitable semiconductors may be used including, but not limited to doped silicon, germanium or gallium arsenide.

"Electronic circuit layers" are electronic circuits usually in a single layer or plane. Electronic circuit layers in the present invention may, but usually do not, by themselves form a complete electrical path. Such layers are usually in the form of a pattern, often formed by etching a metallic plate or film, or may be printed on a substrate, e.g. using polymer thick films. The circuit layers may include components such as semiconductors, as previously mentioned.

"Multilayer circuit" means three or more, electronic circuit layers interspersed with insulating layers and laminated into sandwiches with interconnection between circuit layers by means of conductors which are essentially perpendicular to the circuit layers. "Interconnected" or "interconnection" means that a circuit layer may be directly or indirectly connected to other circuit layers in the multilayer circuit.

"Connecting layer" is a layer which physically holds different circuit layers together. In accordance with the invention connecting layers are insulating along the X and Y axes and conductive along the Z axis. The X and Y axes are those axes of the connecting layer which are parallel to the patterned layers and the Z axis of the connecting layer is the axis which is essentially perpendicular to the patterned layers. By conductive along the Z axis it is meant that conduction will take place at almost any location through the connecting layer along the Z axis, provided that good electrical contact is made on opposing surfaces of the connecting layer. Good electrical contact usually requires that an electrical conductor contact the surface over a surface area at least sixteen times the thickness of the connecting area squared (S=16t²), and preferably as much as fifty times the thickness squared. Much less surface area contact is however required, than has been necessary when through holes have been drilled in insulating layers in the prior art. Such prior art holes are often as large as from 381 to 1143 µm (0.015 to 0.045 inches) in diameter. These prior art holes are in fact often larger than the width of a pattern section which typically can be from 127 to 381 µm (0.005 to 0.015 inches) in width. Since the contact area in accordance with the present invention may be much smaller than 16129 µm² (0.005 inches square (0.000025 in²)) and in fact as small as 645 µm² (0.000001 square inches) or less. It is, however, to be understood that the area of contact may also be arbitrarily chosen to be large in accordance with the invention. A Z-axis connecting layer, as intended in accordance with the present invention, excludes layers which are drilled or etched subsequent to formation to provide later inserted or plated paths which will conduct in the Z direction.

The Z-axis connecting layer, in accordance with the present invention, comprises an electrically insulating material containing electrically conductive particles having a particle size large enough to span the thickness of the connecting layer between conductive portions of the circuit layers which are in contact with the connecting layer and directly opposite each other through the connecting layer so as to insure electrical contact with the particle on both sides of the connecting layer. In other words the particles should have a particle size sufficient to make physical contact between opposing conductive portions (areas of desired electrical contact) of the circuit layers.

The size of the particle in relation to the thickest portion of the connecting layer thickness can vary substantially depending on planarity of pattern conductive portions vs. the surface of the insulating layer. The particles usually have a particle size ranging from five percent up to more than one-hundred percent of the greatest thickness of the adhesive connecting layer, but in any case are usually larger in diameter than the thickness of the connecting layer between conductive portions of the circuit layers which are in contact with the connecting layer and directly opposite each other through the connecting layer. When the phrase "thickness of the connecting layer" is subsequently used herein, the thickness between conductive portions is what is usually intended, which is frequently not the thickest portion of the layer.

The number of particles (loading) in a given volume of insulating material is determined statistically. In particular the number of particles is chosen to keep the probability of short circuits between paths, along the X and Y axes, to an acceptable minimum (usually less than 1 in 1,000,000). Within these constraints the number of particles is desirably maximized to maximize current handling through a desired Z-axis path and if desired to reduce the amount of surface area of the the connecting layer required to make good electrical contact. Usually the loading is between about 1 and about 10 percent by volume and should not exceed Critical Volume Loading (where resin or other insulating material does not coat all area of the particle).

The insulating material used to make the connecting layer may be any dielectric substance, including, but not necessarily limited to, non-conducting plastics and resins, ceramics, and glasses. In accordance with a preferred embodiment of the invention, the insulating material is an insulating plastic or resin, including thermoset and thermoplastic laminating adhesives. It is important that the connecting layer adhere to the circuit layers. Therefore, although the insulating material may not be an adhesive in the traditional sense, it and the connecting layer may nevertheless be referred to herein as adhesive since after pressing and curing they do in fact adhere to circuit layers.

The electrically conductive particles have a particle size at least as large as, but usually no more than ten percent larger than, the thickness of the connecting layer between conductive portions. The thickness of the connecting layer may vary, but is usually between about 12 to about 50 microns (0.5 and 2 mils). The particle sizes therefore typically vary between about 1 to about 60 microns (.04 and 2.2 mils). The particles may be in the form of individual, desirably essentially spherical, particles or in the form of stable (not easily dispersed) agglomerates. Such particles may be of any suitable conductive material including, but not limited to, carbon, gold, copper, palladium, platinum, silver, aluminum, iron, nickel, intrinsically conductive polymers and mixtures thereof. Particularly desirable, in accordance with a preferred embodiment of the invention, are particles which are made of a fusible substance, such as solder, which can be heated and fused to a circuit layer to form a positive electrical connection.

In making the connecting layer, the electrically conductive particles are usually simply blended into the insulating material before the material is spread into a film, usually on a circuit layer, and hardened or cured. Alternatively, the Z-axis adhesive mixture can be coated onto release film and dried for later use. The connecting layer preferably has the ability to physically adhere to the circuit layer (or an insulating film mask over a large portion of the circuit layer). Anisotropic adhesives suitable for use in forming connecting layers are described in U.S. Patent 4,113,981 and copending U.S. patent application serial number 911,342 filed September 25, 1986.

For ease of manufacture, in accordance with a preferred embodiment of the invention, the multilayer electronic circuits are formed by adhering circuit layer pairs together with the anisotropic (Z-axis) connecting layer. Such circuit layer pairs are well known in the art as earlier discussed in the background of the invention. Briefly each such pair comprises an insulating layer, usually an insulating board, having opposing surfaces. The material of construction of the insulating layer may be any suitable dielectric material such as a ceramic, glass or organic polymer. In the preferred embodiment, the insulating layer provides a significant portion of the physical strength of the pair construction. The material should therefore have good strength characteristics. The insulating layer may have any thickness giving suitable dielectric and physical strength properties in a given multilayer circuit. Typical thicknesses range from 12.5 microns to 2 millimeters. Flexible circuits can nevertheless be as thin as 12.7 µm (0.5 mil).

A circuit pattern is formed on each of the insulating layer surfaces by known methods, e.g. by electroless plating the surfaces, applying a photoresist, exposing the surface to an image of the pattern, removing unexposed photoresist, and etching the plating which is unprotected by remaining photoresist to form the pattern. Circuits can also be made by an additive process where conductors are deposited onto the dielectric base. The opposing patterns are then electrically connected at desired locations by holes through the insulating layer which are either plated or filled with metal to form conductors. If desired, additional known methods can be used to form circuit components, such as semiconductor transistors or diodes, capacitors or resistors, onto or into the circuit layer. Resistors may for example be of the thin or thick film types. Such components, as can be seen from the foregoing, may be either active or passive.

In accordance with the preferred embodiment of the invention, at least four circuit layers are provided by using at least two circuit layer pairs by interposing a connecting layer as previously described between one such pattern from each of the pairs. The use of such circuit layer pairs may be continued to increase the number of layers. For example at least three circuit layer pairs may be be provided wherein at least one inner pair is sandwiched between two outer pairs. The pairs are interconnected by means of at least two connecting layers to form a multilayer circuit having at least six electronic circuit layers, i.e. a circuit layer of the first pair is connected by a connecting layer to a first circuit layer of the second pair and the second circuit layer of the second pair is in turn connected by means of another connecting layer to a circuit layer of the third pair. In such a multilayer circuit the insulating layer of the inner circuit layer pairs may be made from a temperature sensitive dielectric, and the insulating layers of the outer circuit layer pairs may be made from heat resistant dielectric to protect the inner layers from the effects of heat during soldering operations. Heat resistant insulating layers for the outer circuit layer pairs may for example be ceramics and certain resins such as thermoset phenolics and PTFE's and more heat sensitive insulating layers for inner circuit layer pairs may for example be plastic materials such as polyethylene, polypropylene, and polyester films.

In preparing circuit layers for connection into a multilayer circuit, it may be desirable to protect the circuit layer with an insulating film mask between the mating circuit layers, except at the conductive portions, i.e. locations where electrical contact is desired. In some circuit patterns, it may not however be necessary to use an isolation mask. This is especially true where the desired conductive portions are raised above the rest of the circuit pattern, e.g. by additional selective plating. Masking is for example easily accomplished by removing remaining exposed photoresist from the circuit pattern, covering the pattern with new unexposed photoresist, exposing the new photoresist with the circuit pattern except at locations of desired contact and removing unexposed photoresist to uncover the desired areas of contact. Optionally and desirably the areas of contact may then be further plated with additional metal to elevate the areas of contact to assist in insuring that good contact is made with conductive particles. It should be pointed out that the areas of contact should be selected to be in opposing registry with corresponding areas of contact on the other circuit pattern to which they are to be connected by the connecting layer.

It should also be pointed out that careful alignment should be made, e.g. by means of registering pins, to insure that such corresponding areas of contact directly oppose each other through the connecting layer. While such registration is important, it is much simpler than many prior art systems which required that all layers be simultaneously registered or aligned.

In summary the multilayer circuits of the invention, in accordance with a preferred embodiment, may be manufactured as follows. Circuit pairs are made as previously described which comprise an insulating layer having opposing surfaces and having a circuit pattern on each opposing surface. The patterns in each pair are connected by means of conductors passing through the insulating layer. The circuit patterns in each pair which are to be connected into the multilayer circuit by contact with a connecting layer may be covered with an insulating mask, except at locations of desired electrical contact. Pairs are connected by interposing an adhesive connecting layer between one masked pattern from the pairs to be directly connected to each other. The thickness of the z-axis connecting layer used is determined as previously discussed. Also as previously discussed, the quantity of conductive particles in the connecting layer is statistically selected so as to be sufficiently dispersed to prevent electrical conduction along the X and Y axes of the connecting layer and sufficiently concentrated to insure electrical contact through the Z-axis of the connecting layer between unmasked portions of the circuit patterns which are in contact with the connecting layer and directly opposite each other through the connecting layer.

Desirably, subsequently to connecting the pairs by interposing the connecting layer, the resulting connected pairs are pressed together to enhance lamination and appropriate electrical contact. The pressing may occur for example in a platen. The pressing pressure may vary but would usually range between 6,8 g and 2756 kPa (1 and 400 pounds per square inch). If the connecting layer comprises a heat curable resin, during or subsequent to such pressing, the resin may be heat cured. Similarly, since the conductive particles are fusible, the particles may be fused to the areas of desired electrical contact to form a positive electrical connection either during or after pressing. The particles may be fused either by heating the entire multilayer circuit or by selectively heating the particles, e.g. by means of a relatively high electric current for the current carrying capacity of the particles or by microwaves. Alternatively, flexible circuits may be bonded together with a heated roll in a roll-to-roll process.

For a more detailed discussion of a preferred embodiment of the invention reference may be had to the drawings. It is to be understood that the drawings are intended to illustrate an embodiment of the invention and are not intended to be limiting.

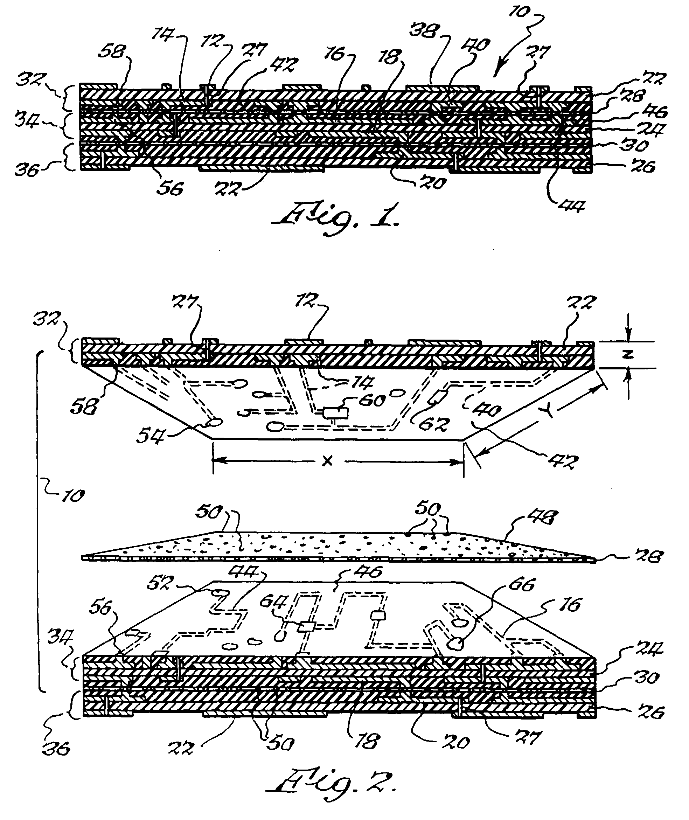

As can best be seen in Figures 1 and 2, a multilayer circuit 10 is provided which comprises circuit layers 12, 14, 16, 18, 20 and 22; insulating layers 22, 24 and 26; and connecting layers 28 and 30. The multilayer circuit shown consists of the six circuit layers in three circuit layer pairs 32, 34 and 36. Circuit layer pair 32 comprises circuit layers 12 and 14 secured to insulating layer 22, circuit layer pair 34 comprises circuit layers 16 and 18 secured to insulating layer 24 and circuit layer pair 36 comprises circuit layers 20 and 22 secured to insulating layer 26. The layers in the pairs are connected to each other through the insulating layers by means of conductors, e.g. shown as 27 in the drawings. Circuit layer 12 comprises circuit pattern 38; whereas, circuit layer 14 comprises a circuit pattern 40 as well as insulating film mask 42. Similarly circuit layer 16 comprises circuit pattern 44 and insulating mask 46. Circuit layers 18 and 20 also comprise both a circuit pattern and a mask. Circuit layer 22 comprises a pattern only. It is to be understood that circuit layers 12 and 22 can easily be provided with masks if desired. The circuit layers of the pairs are interconnected by means of connecting layers 28 and 30. As seen in the drawings, connecting layer 28 connects circuit layers 14 and 16 and connecting layer 30 connects circuit layers 18 and 20. The connecting layers comprise both a resin 48 and electrically conductive particles 50. The particles connect unmasked conductive portions of the circuit patterns, e.g. unmasked portions 52 and 54 are connected , as are unmasked portions 56 and 58. The circuit pattern may include electronic components, e.g. semiconductor components 60, 62, 64 and 66.

The following example serves to illustrate and not limit the present invention.

### Example

Thermoplastic solid polyester resin pellets melting at about 130°C (duPont 49000) are dissolved in a 1:1 volume blend of butryolactone and cyclohexanone to make a 40% solids solution designated as resin A.

Thermoplastic solid polyester resin pellets melting at about 60°C (duPont 49001) are dissolved in a 1:1 volume blend of butryolactone and cyclohexanone to make a 40% solids solution designated as resin B.

The following ingredients are blended together:

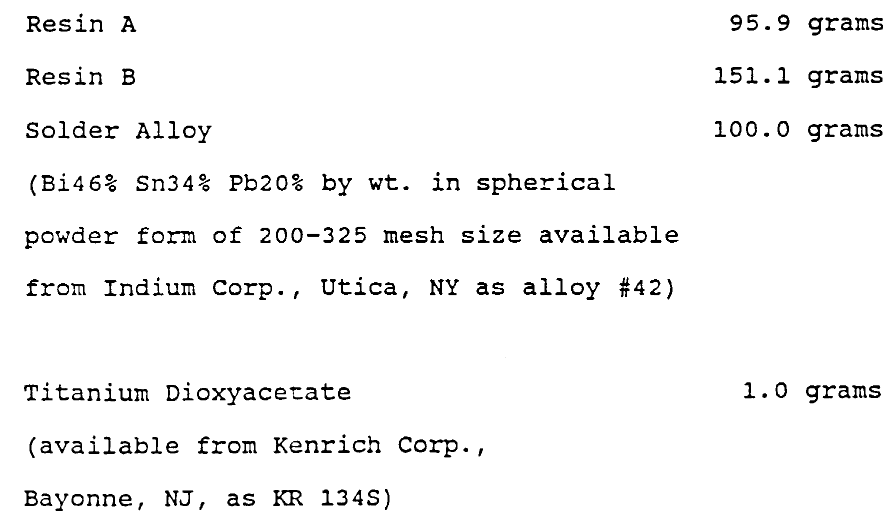

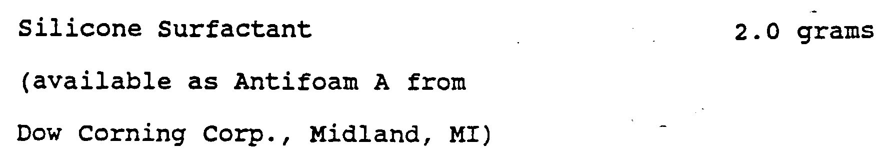

The ingredients are mixed with rapid agitation until the solder powder is thoroughly dispersed. A small amount of mix can be coated on a plastic sheet and examined microscopically. Particles should be evenly distributed with no agglomerates.

The mixture is coated onto a dual sided circuit board, intended for mating to a second board to produce a multilayer structure. Only one board of the mating pair needs to be coated. A wire wound rod or laboratory coating bar can be used. A wet coating film of 12.7 to 38.1 µm (.5 to 1.5 mils) in thickness is applied and dried at 70°C for 20 minutes.

The coated board is aligned to a second board which has opposing conductor pads (conductor portions) corresponding to those of the first board.

The aligned circuits are placed in a heated platen press under the following conditions:

| | |
|---|---|
| Temperature: | 116°C (±11°C) (240°F (±20°F)) |
| Pressure: | 344,5 kPa (±137,8 kPa) (50 PSI (±20 PSI)) |
| Dwell: | 40 seconds (+20, -10 sec.) |

The resulting multilayer circuit is tested for continuity and short circuits. Continuity is found along all paths desired, including those between the dual sided boards, and no short circuits (undesired circuit paths) are found.

## Claims

1. A multilayer electronic circuit comprising at least three electronic circuit layers (32, 34, 36) electrically interconnected to one another,
wherein
at least two of said electronic circuit layers (32, 34, 36) are electrically interconnected by means of at least one interposed connecting layer (28, 30) which is conductive only in the Z-axis and which is substantially coextensive with at least one of said circuit layers (32, 34, 36), wherein the connected distance between said circuit layers (32, 34, 36) is about 12 to 50 µm, wherein the Z-axis conductivity arises from an adhesive (48) with dispersed deformable and heat fusible metal particles (50) having a particle size with a diameter of at least about 40 µm (retained by a sieve with mesh number 325) and about equal to the connected distance between said layers (32, 34, 36), wherein the particles (50) are sufficiently dispersed from one another to prevent electrical conduction along the X- and Y-axes of the connecting layer (28, 30) substantially throughout the entire connecting layer (28, 30) and are sufficiently concentrated to insure electrical contact through the Z-axis of the connecting layer (28, 30) between conductive portions of the circuit layers (32, 34, 36) which are in contact with the connecting layer (28, 30) and directly opposite each other through the connecting layer (28, 30), and wherein said particles (50) are fused to form a positive connection between said opposing conductive portions of the circuit layers (32, 34, 36) in contact with the connecting layer (28, 30).

2. The multilayer electronic circuit of claim 1 wherein at least four circuit layers are provided in two circuit layer pairs comprising an insulating layer each pair having opposing surfaces and having a circuit pattern on each of the opposing surfaces of the insulating layer, which patterns in each pair are connected by means of conductors passing through the insulating layer, said pairs being connected by means of said connecting layer comprising an electrically insulating material interposed between one such pattern from each of said pairs.

3. The multilayer circuit of claim 1 wherein the connecting layer comprises an electrically insulating material containing electrically conductive particles, the quantity of said particles being statistically selected so as to be sufficiently dispersed from one another to prevent electrical conduction along the X and Y axes of the connecting layer substantially throughout the entire connecting layer and sufficiently concentrated and of a size to insure electrical contact through the Z-axis of the connecting layer between conductive portions of said circuit layers which are in contact with the connecting layer and directly opposite each other through the connecting layer.

4. The multilayer electronic circuit according to claim 2 or 3 wherein the insulating material is a resin.

5. The multilayer electronic circuit of claim 2 wherein at least three circuit layer pairs are provided wherein at least one inner circuit layer pair is sandwiched between two outer circuit layer pairs, said pairs being interconnected by means of at least two connecting layers to form a multilayer circuit having at least six electronic circuit layers.

6. The multilayer electronic circuit of claim 3 wherein the electrically conductive particles are essentially spherical and have a diameter between 100 and 110 % of the thickness of the connecting layer between conductive portions.

7. The circuit of claim 3 wherein the metal particles are a heat fusible metallic substance.

8. The circuit of claim 7 wherein the metallic substance is a low temperature solder.

9. The multilayer electronic circuit of claim 1 wherein at least some of the circuit layers include semiconductor components.

10. The multilayer electronic circuit of claim 1 wherein at least some of the circuit layers include passive components.

11. The multilayer circuit of claim 3 wherein the circuit layers are covered by an insulating film mask, except at conductive portions where contact through the connecting layer is desired.

12. The multilayer circuit of claim 5 wherein the insulating layer of the inner circuit layer pair is made from a temperature sensitive dielectric, and the insulating layers of the outer circuit layer pairs are made from heat resistant dielectric.

13. A method for making a multilayer electronic circuit comprising:
(a) making circuit layer pairs each pair comprising an insulating layer having opposing surfaces and having a circuit pattern on each of the opposing surfaces of the insulating layer, which patterns in each pair are connected by means of conductors passing through the insulating
(b) connecting at least two of such pairs by interposing an adhesive connecting layer so that the connected distance between the circuit layers is about 12 to 50 µm, said adhesive connecting layer being substantially coextensive with at least one layer of the pair, said adhesive connecting layer comprising an electrically insulating resin containing heat fusible electrically conductive particles, said particles being deformable under pressure, the quantity of said particles being statistically selected so as to be sufficiently dispersed from one another to prevent electrical conduction along the X and Y axes of the connecting layer substantially throughout the entire connecting layer and sufficiently concentrated to insure electrical contact through a Z-axis of the connecting layer between conductive portions of the circuit patterns which are in contact with the connecting layer and directly opposite each other through the connecting layer, wherein said particles are fused to form a positive connection to said conductive portions of the circuit patterns in contact with the connecting layer and wherein the Z-axis conductivity arises from an adhesive with dispersed deformable and heat fusible metal particles having a particle size with a diameter of at least 40 µm, retained by a sieve of mesh size 325, and about equal to the connected distance between the circuit layers.

14. The method of claim 13 wherein subsequent to connecting said pairs by interposing said adhesive connecting layer, the resulting connected pairs are pressed to insure good lamination and electrical contact.

15. The method of claim 13 wherein subsequent to connecting said pairs by interposing said adhesive connecting layer, the adhesive connecting layer is heat cured.

16. The method of claim 14 wherein subsequent to connecting said pairs by interposing said adhesive connecting layer, the adhesive connecting layer is heat cured.

17. The method of claim 13 wherein prior to connecting with the connecting layer, at least one of the circuit patterns of each pair is covered with an insulating mask, except at the conductive portion areas of desired electrical contact.

18. The method of claim 17 wherein subsequent to covering a circuit pattern with an insulating mask, the exposed locations of desired electrical contact are treated with an electrically conductive material to elevate such locations to at least the surface of the mask.

19. The method of claim 13 wherein the electrically conductive particles are essentially spherical and have a diameter about 100 to 110% of the thickness of the connecting layer between conductive portions.

20. The method of claim 13 wherein the particles are a heat fusible metallic substance and subsequent to connecting by interposing the adhesive connecting layer the particles are fused to form a positive connection to said conductive portions of the circuit patterns in contact with the adhesive connecting layer by a heated roll in a roll-to-roll process.

21. The method of claim 20 wherein the metallic substance is a low temperature solder.

22. The method of claim 13 wherein at least some of the circuit layers include semiconductor components.

23. The method of claim 13 wherein the conductive particles are composed of intrinsically conductive polymers.

24. The method of claim 13 wherein the circuit patterns are made from polymer thick film.

25. The multilayer circuit of claim 1, wherein the connecting layer is configured to exhibit high resistance to thermal stress such that the multilayer circuit is capable of withstanding high temperature post-processing assembly operations and operational environments.

26. The method of claim 13, wherein the connecting layer is configured to exhibit high resistance to thermal stress such that the multilayer circuit is capable of withstanding high temperature post-processing assembly operations and operational environments.

## Patentansprüche

1. Mehrlagiger elektronischer Schaltkreis mit zumindest drei elektronischen Schaltkreislagen (32, 34, 36), die miteinander elektrisch verbunden sind,
wobei
zumindest zwei der elektronischen Schaltkreislagen (32, 34, 36) mit Hilfe von zumindest einer dazwischen liegenden Verbindungsschicht (28, 30) elektrisch miteinander verbunden sind, die nur entlang der Z-Achse leitfähig ist und die sich im wesentlichen gemeinsam mit bzw. parallel zu zumindest einer der Schaltkreislagen (32, 34, 36) erstreckt, wobei der Abstand zwischen den Schaltkreislagen (32, 34, 36) im miteinander verbundenen Zustand etwa 12 bis 50 µm beträgt, wobei die Z-Achse-Leitfähigkeit von einem Klebemittel (48) mit darin verteilten, verformbaren und unter Wärme aufschmelzbaren Metallteilchen (50) herrührt, die eine Teilchengröße mit einem Durchmesser von zumindest etwa 40 µm haben, wie sie durch ein Sieb mit der Siebzahl 325 zurückgehalten werden, und in etwa gleich dem Verbindungsabstand zwischen den Lagen (32, 34, 36), wobei die Teilchen (50) ausreichend gut verteilt bzw. voneinander beabstandet sind, so daß eine elektrische Leitfähigkeit entlang der X- und Y-Achsen der Verbindungsschicht (28, 30) im wesentlichen über die gesamte Verbindungsschicht (28, 30) hinweg verhindert wird, und ausreichend konzentriert sind, daß sie den elektrischen Kontakt entlang der Z-Achse der Verbindungsschicht (28, 30) zwischen leitfähigen Teilen der Schaltkreislagen (32, 34, 36) sicherstellen, die in Kontakt mit der Verbindungsschicht (28, 30) stehen und über die Verbindungsschicht (28, 30) einander direkt gegenüberliegen, und wobei die Teilchen (50) aufgeschmolzen sind, um eine gute Verbindung zwischen den einander gegenüberliegenden leitfähigen Teilen der Schaltkreislagen (32, 34, 36) in Kontakt mit der Verbindungsschicht (28, 30) zu bilden.

2. Mehrlagiger elektronischer Schaltkreis nach Anspruch 1, wobei zumindest vier Schaltkreislagen in zwei Schaltkreislagenpaaren vorgesehen sind, wobei jedes Paar eine Isolierschicht aufweist mit einander gegenüberliegenden Oberflächen und ein Schaltkreismuster auf jeder der Isolierschicht gegenüberliegenden Oberflächen hat, wobei die Muster in jedem Paar mit Hilfe von elektrischen Leitem verbunden sind, die durch die Isolierschicht hindurch verlaufen, und wobei die Paare mit Hilfe der Verbindungsschicht miteinander verbunden sind, die zwischen dem einen der Muster von jedem der Paare angeordnet ist.

3. Mehrlagiger elektronischer Schaltkreis nach Anspruch 1, wobei die Verbindungsschicht ein elektrisch isolierendes Material aufweist, welches elektrisch leiffähige Teilchen enthält, wobei die Menge der Teilchen statistisch ausgewählt wird, so daß sie ausreichend verteilt sind, um eine elektrische Leitfähigkeit entlang der X- und Y-Achsen der Verbindungsschicht im wesentlichen durch die gesamte Verbindungsschicht hinduch zu verhindern, und ausreichend konzentriert und von einer Größe sind, daß sie einen elektrischen Kontakt entlang der Z-Achse der Verbindungsschicht zwischen leitfähigen Teilen der Schaltkreislagen sicherstellen, die mit der Verbindungsschicht in Kontakt stehen und über die Verbindungsschicht direkt einander gegenüberliegen.

4. Mehrlagiger elektronischer Schaltkreis nach Anspruch 3, wobei das Isoliermaterial ein Harz ist.

5. Mehrlagiger elektronischer Schaltkreis nach Anspruch 2, wobei zumindest drei Schaltkreislagenpaare vorgesehen sind, wobei zumindest ein inneres Schaltkreislagenpaar sandwichartig zwischen den beiden äußeren Schaltkreislagenpaaren angeordnet ist und wobei die Paare mit Hilfe von zumindest zwei Verbindungsschichten miteinander verbunden sind, um einen mehrlagigen Schaltkreis zu bilden, der zumindest sechs elektronische Schaltkreislagen hat.

6. Mehrlagiger elektronischer Schaltkreis nach Anspruch 3, wobei die elektrisch leitfähigen Teilchen im wesentlichen kugelförmig sind und einen Durchmesser zwischen 100 und 110% der Dicke der Verbindungsschicht zwischen den leitfähigen Abschnitten haben.

7. Mehrlagiger elektronischer Schaltkreis nach Anspruch 3, wobei die Metallteilchen eine unter Wärme schmelzbare metallische Substanz sind.

8. Mehrlagiger elektronischer Schaltkreis nach Anspruch 7, wobei die metallische Substanz ein Niedrigtemperatur-Lötmittel ist.

9. Mehrlagiger elektronischer Schaltkreis nach Anspruch 1, wobei zumindest einige der Schaltkreislagen Halbleiterbauteile aufweisen.

10. Mehrlagiger elektronischer Schaltkreis nach Anspruch 1, wobei zumindest einige der Schaltkreislagen passive Komponenten aufweisen.

11. Mehrlagiger elektronischer Schaltkreis nach Anspruch 3, wobei die Schaltkreislagen mit Ausnahme der leitfähigen Abschnitte, an welchen ein Kontakt durch die Verbindungsschicht erwünscht ist, durch eine Isolierfilmmaske abgedeckt sind.

12. Mehrlagiger elektronischer Schaltkreis nach Anspruch 5, wobei die Isolierschicht des inneren Schaltkreislagenpaares aus einem temperaturempfindlichen Dielektrikum hergestellt ist und die Isolierschichten der äußeren Schaltkreislagenpaare aus einem wärmebeständigen Dielektrikum hergestellt sind.

13. Verfahren zum Herstellen eines mehrlagigen elektronischen Schaltkreises mit:
a) Herstellen von Paaren von Schaltkreislagen, wobei jedes Paar eine Isolierschicht mit entgegengesetzten Oberflächen sowie ein Schaltkreismuster auf jeder der gegenüberliegenden Flächen der Isolierschicht hat, wobei diese Muster bei jedem Paar mit Hilfe von elektrischen Leitern verbunden sind, die durch die Isolierschicht hindurchverlaufen; und
b) Verbinden von zumindest zwei derartigen Paaren durch Dazwischenanordnen einer klebenden Verbindungsschicht, so daß der Verbindungsabstand zwischen den Schaltkreislagen etwa 12 - 50 µm beträgt, wobei die klebende Verbindungsschicht sich im wesentlichen entlang zumindest einer Lage des Paares erstreckt und ein elektrisch isolierendes Harz aufweist, welches durch Wärme aufschmelzbare, elektrisch leiffähige Teilchen aufweist, wobei die Teilchen unter Druck verformbar sind und die Menge der Teilchen statistisch so ausgewählt wird, daß sie ausreichend verteilt bzw. voneinander getrennt sind, so daß eine elektrische Leitfähigkeit entlang der X- und Y-Achsen der Verbindungsschicht im wesentlichen über die gesamte Verbindungsschicht hinweg verhindert wird, und ausreichend konzentriert sind, um einen elektrischen Kontakt entlang der Z-Achse der Verbindungsschicht zwischen leitfähigen Teilen der Schaltkreismuster sicherzustellen, welche mit der Verbindungsschicht in Kontakt stehen und über die Verbindungsschicht einander direkt gegenüberliegen, wobei die Teilchen auf- bzw. angeschmolzen werden, um eine feste Verbindung mit den leitfähigen Teilen der Schaltkreismuster zu bilden, die in Kontakt mit der Verbindungsschicht stehen, und wobei die Z-Achsen-Leitfähigkeit von einem Klebemittel mit darin verteilten, verformbaren und unter Wärme aufschmelzbaren Metallteilchen herrührt, die eine Teilchengröße mit einem Durchmesser von zumindest 40 µm haben, wie sie durch ein Sieb der Siebgröße 325 zurückgehalten werden, und die in etwa gleich dem Verbindungsabstand zwischen den Schaltkreislagen ist.

14. Verfahren nach Anspruch 13, wobei im Anschluß an das Verbinden der Paare durch Dazwischenanordnen der klebenden Verbindungsschicht die daraus hervorgehenden, verbundenen Paare zusammengepreßt werden, um eine gute Beschichtung bzw. Benetzung und elektrischen Kontakt sicherzustellen.

15. Verfahren nach Anspruch 13, wobei im Anschluß an das Verbinden der Paare durch Dazwischenanordnen der klebenden Verbindungsschicht diese klebende Verbindungsschicht unter Wärme ausgehärtet wird.

16. Verfahren nach Anspruch 14, wobei im Anschluß an das Verbinden der Paare durch Dazwischenanordnen der klebenden Verbindungsschicht die klebende Verbindungsschicht unter Wärme ausgehärtet wird.

17. Verfahren nach Anspruch 13, wobei vor dem Verbinden mit der Verbindungsschicht zumindest eines der Schaltkreismuster jedes Paares mit Ausnahme der leitfähigen Flächenbereiche, an denen ein elektrischer Kontakt gewünscht wird, mit einer Isoliermaske abgedeckt wird.

18. Verfahren nach Anspruch 17, wobei im Anschluß an das Abdecken eines Schaltkreismusters mit einer Isoliermaske die offenliegenden Stellen des gewünschten elektrischen Kontaktes mit einem elektrisch leitfähigen Material behandelt werden, um derartige Stellen zumindest bis auf die Oberfläche der Maske anzuheben.

19. Verfahren nach Anspruch 13, wobei die elektrisch leitfähigen Teilchen im wesentlichen kugelförmig sind und einen Durchmesser von etwa 100 - 110% der Dicke der Verbindungsschicht zwischen den leitfähigen Abschnitten haben.

20. Verfahren nach Anspruch 13, wobei die Teilchen aus einer unter Wärme aufschmelzbaren metallischen Substanz bestehen und im Anschluß an das Verbinden durch Dazwischenanordnen der klebenden Verbindungsschicht aufgeschmolzen bzw. angeschmolzen werden, um eine feste Verbindung mit den leitfähigen Abschnitten der Schaltkreismuster zu bilden, die mit der klebenden Verbindungsschicht in Kontakt stehen, und zwar durch eine geheizte Walze in einem Walzvorgang mit aneinander bzw. gegenüberliegenden Walzen.

21. Verfahren nach Anspruch 20, wobei die metallische Substanz ein Niedrigtemperaturlötmittel ist.

22. Verfahren nach Anspruch 13, wobei zumindest einige der Schaltkreisschichten Halbleiterkomponenten aufweisen.

23. Verfahren nach Anspruch 13, wobei die leitfähigen Teilchen aus intrisisch leitfähigen Polymeren bestehen.

24. Verfahren nach Anspruch 13, wobei die Schaltkreismuster aus einem Dickschichtpolymer bzw. einer polymeren Dickschicht hergestellt sind.

25. Mehrlagiger elektronischer Schaltkreis nach Anspruch 1, wobei die Verbindungsschicht so ausgestaltet ist, daß sie eine hohe Widerstandsfähigkeit gegen thermische Spannungen hat, so daß der mehrlagige elektronische Schaltkreis in der Lage ist, nach der Herstellung Montage- bzw. Bestückungsvorgänge und Betriebsbedingungen unter hohen Temperaturen auszuhalten.

26. Verfahren nach Anspruch 13, wobei die Verbindungsschicht so ausgestaltet ist, daß sie eine hohe Widerstandsfähigkeit gegen thermische Spannungen hat, so daß der mehrlagige elektronische Schaltkreis in der Lage ist, nach der Herstellung Montage- bzw. Bestückungsvorgänge und Betriebsbedingungen unter hohen Temperaturen auszuhalten.

## Revendications

1. Circuit électronique multicouche comprenant au moins trois couches de circuit électronique (32, 34, 36) interconnectées électriquement l'une à l'autre,
dans lequel
au moins deux desdites couches de circuit électronique (32, 34, 36) sont interconnectées électriquement au moyen d'au moins une couche de connexion interposée (28, 30) qui est conductrice seulement dans la direction de l'axe des Z et qui s'étend sensiblement comme au moins l'une desdites couches de circuit (32, 34, 36), dans lequel la distance de connexion entre lesdites couches de circuit (32, 34, 36) est d'environ 12 à 50 µm, dans lequel circuit la conductivité selon l'axe des Z s'élève à partir d'un adhésif (48) comportant des particules (50) dispersées de métal déformables et fusibles à la chaleur, ayant une dimension de diamètre de particules d'au moins environ 40 µm (retenues par un tamis présentant un nombre de mesh de 325) et d'épaisseur sensiblement égale à la distance de connexion entre lesdites couches (32, 34, 36), dans lequel les particules (50) sont suffisamment dispersées les unes par rapport aux autres pour empêcher une conduction électrique le long des axes X et Y de la couche de connexion (28, 30) sensiblement à travers toute la couche de connexion (28, 30), et sont suffisamment concentrées pour assurer un contact électrique selon l'axe des Z de la couche de connexion (28, 30) entre les parties conductrices des couches de circuit (32, 34, 36) qui sont en contact avec la couche de connexion (28, 30) et directement opposées l'une par rapport à l'autre par l'intermédiaire de la couche de connexion (28, 30), et dans lequel lesdites particules (50) sont fondues de façon à former une connexion positive entre lesdites parties conductrices en opposition des couches de circuit (32, 34, 36) qui sont en contact avec la couche de connexion (28, 30).

2. Circuit électronique multicouche selon la revendication 1, dans lequel au moins quatre couches de circuit sont prévues en deux paires de couches de circuit comprenant une couche d'isolation, chaque paire présentant des surfaces en opposition et ayant un motif de circuit sur chacune des surfaces en opposition de la couche d'isolation, les motifs de chaque paire étant connectés au moyen de conducteurs traversant la couche d'isolation, lesdites paires étant connectées au moyen de ladite couche de connexion comprenant un matériau isolant électrique interposé entre l'un des motifs de chacune desdites paires.

3. Circuit multicouche selon la revendication 1, dans lequel la couche de liaison comprend un matériau isolant électrique contenant des particules électriquement conductrices, la quantité desdites particules étant statistiquement choisie de façon que les particules soient suffisamment dispersées entre elles pour empêcher une conduction électrique le long des axes X et Y de la couche de connexion sensiblement sur toute la couche de connexion, et de façon à être suffisamment concentrée et d'une dimension appropriée pour assurer le contact électrique selon l'axe des Z de la couche de connexion entre les parties conductrices desdites couches de circuit qui sont en contact avec la couche de connexion et directement en opposition l'une à l'autre à travers la couche de connexion.

4. Circuit électronique multicouche selon la revendication 2 ou 3, dans lequel le matériau isolant est une résine.

5. Circuit électronique multicouche selon la revendication 2, dans lequel au moins trois paires de couches de circuit sont prévues, dans lequel au moins la paire de couches de circuit interne est prise en sandwich entre deux paires de couches de circuit externes, lesdites paires étant interconnectées au moyen d'au moins deux couches de connexion de façon à former un circuit multicouche comportant au moins six couches de circuit électronique.

6. Circuit électronique multicouche selon la revendication 3, dans lequel les particules électriquement conductrices sont essentiellement sphériques et présentent un diamètre compris entre 100 et 110 % de l'épaisseur de la couche de connexion entre les parties conductrices.

7. Circuit selon la revendication 3, dans lequel les particules métalliques sont constituées par une substance métallique fusible à la chaleur.

8. Circuit selon la revendication 7, dans lequel la substance métallique est une soudure à basse température.

9. Circuit électronique multicouche selon la revendication 1, dans lequel au moins certaines des couches de circuit comprennent des composants semi-conducteurs.

10. Circuit électronique multicouche selon la revendication 1, dans lequel au moins certaines des couches de circuit comprennent des composant passifs.

11. Circuit multicouche selon la revendication 2, dans lequel les couches de circuit sont recouvertes par un masque d'un film isolant, à l'exception des parties conductrices là où s'effectuent les contacts à travers la couche de connexion.

12. Circuit multicouche selon la revendication 5, dans lequel la couche d'isolation de la paire de couches de circuit interne est constituée d'un diélectrique sensible à la température, et les couches d'isolation des paires de couches de circuit externes sont fabriquées à partir d'un diélectrique résistant à la température.

13. Procédé de fabrication d'un circuit électronique multicouche comprenant les étapes consistant à :
(a) fabriquer des paires de couches de circuit, chaque paire comprenant une couche d'isolation ayant des surfaces en opposition et ayant un motif de circuit sur chacune des surfaces en opposition de la couche d'isolation, lesquels motifs dans chaque paire sont connectés au moyen de conducteurs traversant la couche d'isolation ; et
(b) connecter au moins deux telles paires en interposant une couche de connexion adhésive de telle façon que la distance connectée entre les couches de circuit soit comprise entre environ 12 et 50 µm, ladite couche de connexion adhésive s'étendant sensiblement comme au moins une couche de la paire, ladite couche de connexion adhésive comprenant une résine isolante électriquement contenant des particules électriquement conductrices fusibles à la chaleur, lesdites particules pouvant être déformées sous pression, la quantité desdites particules étant statistiquement choisie de façon qu'elles soient suffisamment dispersées entre elles pour empêcher une conduction électrique le long des axes X et Y de la couche de connexion sensiblement à travers toute la couche de connexion et étant suffisamment concentrées pour assurer un contact électrique selon l'axe des Z de la couche de connexion entre les parties conductrices des motifs de circuit qui sont en contact avec la couche de connexion et directement en opposition l'une à l'autre à travers la couche de connexion, dans lequel lesdites particules sont fondues de façon à former une connexion positive avec lesdites parties conductrices des motifs de circuit qui sont en contact avec la couche de connexion, et dans lequel la conductivité selon l'axe des Z s'élève à partir d'un adhésif comprenant des particules dispersées de métal fusibles à la chaleur et déformables, ayant une dimension de diamètre de particules d'au moins 40 µm, retenues par un tamis présentant un nombre de mesh de 325, et d'épaisseur sensiblement égale à la distance de connexion entre les couches de circuit.

14. Procédé selon la revendication 13, dans lequel, suite à la connexion desdites paires par interposition de ladite couche de connexion adhésive, les paires connectées résultantes sont pressées de façon à assurer un bon contact électrique et une bonne forme en feuille.

15. Procédé selon la revendication 13, dans lequel suite à la connexion desdites paires par interposition de ladite couche de connexion adhésive, la couche de connexion adhésive est traitée à la chaleur.

16. Procédé selon la revendication 14, dans lequel suite à la connexion desdites paires par interposition de ladite couche de connexion adhésive, la couche de connexion adhésive est traitée à la chaleur.

17. Procédé selon la revendication 13, dans lequel avant d'effectuer la connexion avec la couche de connexion, au moins l'un des motifs de circuit de chaque paire est recouvert d'un masque isolant, à l'exception des aires des parties conductrices où sont réalisés les contacts électriques désirés.

18. Procédé selon la revendication 17, dans lequel après recouvrement d'un motif de circuit avec un masque isolant, les emplacements exposés de contact électrique souhaité sont traités au moyen d'un matériau conducteur électrique de façon à élever ces emplacements au moins jusqu'à la surface du masque.

19. Procédé selon la revendication 13, dans lequel les particules électriquement conductrices sont essentiellement sphériques et ont un diamètre compris entre environ 100 et 110 % de l'épaisseur de la couche de connexion entre les parties conductrices.

20. Procédé selon la revendication 13, dans lequel les particules sont constituées par une substance métallique fusible à la chaleur et qu'à la suite de la connexion par interposition de la couche de connexion adhésive, les particules sont fondues de façon à former une connexion positive sur lesdites parties conductrices des motifs de circuit en contact avec la couche de connexion adhésive au moyen d'un rouleau chauffé dans un procédé rouleau à rouleau.

21. Procédé selon la revendication 20, dans lequel la substance métallique est une soudure à basse température.

22. Procédé selon la revendication 13, dans lequel au moins l'une des couches du circuit comprend des composants semi-conducteurs.

23. Procédé selon la revendication 13, dans lequel les particules conductrices sont constituées de polymères intrinsèquement conducteurs.

24. Procédé selon la revendication 13, dans lequel les motifs de circuit sont fabriqués à partir d'un film épais polymère.

25. Circuit multicouche selon la revendication 1, dans lequel la couche de connexion est configurée de façon à présenter une résistance élevée à la contrainte thermique telle que le circuit multicouche soit susceptible de résister à des températures élevées lors d'opérations d'assemblage postérieures au traitement et dans des environnements opérationnels.

26. Procédé selon la revendication 13, dans lequel la couche de connexion est configurée de façon à présenter une résistance élevée à la contrainte thermique telle que le circuit multicouche soit susceptible de résister à des températures élevées lors d'opérations d'assemblage postérieures au traitement et dans des environnements opérationnels.
